# EUROPÄISCHE PATENTSCHRIFT

(11) **EP 1 998 182 B1**
(45) Veröffentlichungstag und Bekanntmachung des Hinweises auf die Patenterteilung: **08.06.2016**
(21) Anmeldenummer: 08103324.3
(22) Anmeldetag: 02.04.2008
(51) Int. Cl.: G01R 29/08, G01V 8/00

(54) **Elektrisches Gerät, das mit einem mikrowellensensitiven Element ausgestattet ist**
Electric device equipped with a microwave sensor
Appareil électrique comportant un capteur micro-onde

(30) Priorität: 30.05.2007 DE 102007024966
(43) Veröffentlichungstag der Anmeldung: 03.12.2008
(73) Patentinhaber: ROBERT BOSCH GMBH, 70442 Stuttgart (DE)
(72) Erfinder: Merkle, Michael, 70192 Stuttgart (DE)

(56) Entgegenhaltungen:
- WO-A-98/36287
- WO-A-03/083495
- WO-A-2006/040385
- DE-A1- 10 249 673
- US-A- 4 539 567

## Beschreibung

### Stand der Technik

Die Erfindung geht von einem elektrischen Gerät nach der Gattung des unabhängigen Patentanspruchs aus.

Beispielsweise aus Derwent Abstract zu RU 2148266 C1 ist es bekannt, elektrische Schaltkreise von Funkanlagen durch gezielte Mikrowellenbestrahlung zu zerstören. Die Zerstörung elektrischer Schaltkreise durch Mikrowellenbestrahlung wird zunehmend auch von Endverbrauchern im Bereich der Consumer-Elektronik praktiziert, um auf dem Wege der Hersteller-Gewährleistung günstig an neue Geräte zu gelangen.

### Vorteile der Erfindung

Die Erfindung mit den Merkmalen des unabhängigen Patentanspruchs ermöglicht eine für den Gerätehersteller erleichterte Prüfung dahingehend, ob ein Gerätedefekt auf eine Mikrowellenbestrahlung zurückzuführen ist. Damit einher gehen eine schnelle und kostengünstige Schadensanalyse, die Möglichkeit der Erkennung einer vorsätzlichen Beschädigung des Geräts durch Mikrowellenstrahlung und die Vermeidung von Kosten durch unberechtigte Gewährleistungsansprüche.

Zwar sind Mikrowellensensoren an sich bekannt. So beschreibt die US 4,539,567 ein Messgerät zur Erfassung von Elektrosmog, die DE 102 49 673 A1 ein Elektromagnetfelddosismeter und die WO 98/36287 ein Gerät für Militärzwecke, das im Zusammenhang mit hohen Mikrowellenimpulsen steht, einen Manipulationsschutz bieten diese Lösungen nicht.

Vorteilhaft sind das mikrowellensensitive Element und das Speicherelement in einem Gehäuse, angeordnet, in dem auch der elektrische Schaltkreis angeordnet ist.

Gemäß einer vorteilhaften Ausführungsform können das mikrowellensensitive Element und das Speicherelement als ein gemeinsames Sensor- und Speicherelement ausgebildet sein. Vorteilhaft ist dabei das gemeinsame Sensor- und Speicherelement in Form eines Metallstreifens oder einer Metallfolie realisiert, die bei Mirkowellenbestrahlung infolge der dadurch induzierten Wirbelströme erhitzt und bei Überschreiten einer bestimmten Bestrahlungsintensität oder -dosis irreversibel zerstört wird. Alternativ kann das gemeinsame Sensor- und Speicherelement vorteilhaft in Form eines elektrischen Schwingkreises realisiert sein, der bei Anregung im Bereich seiner Resonanzfrequenz mit einer bestimmten Mindestintensität irreversibel zerstört wird.

Vorteilhaft sind das Sensorelement und/oder das Speicherelement von dem elektrischen Schaltkreis elektrisch entkoppelt. Dadurch kann sichergestellt werden, dass das Sensorelement auch dann noch ein eine Mikrowellenbestrahlung anzeigendes Signal erzeugen kann, wenn der elektrische Schaltkreis infolge der Bestrahlung bereits zerstört oder zumindest in Teilen funktionsunfähig ist.

### Zeichnungen

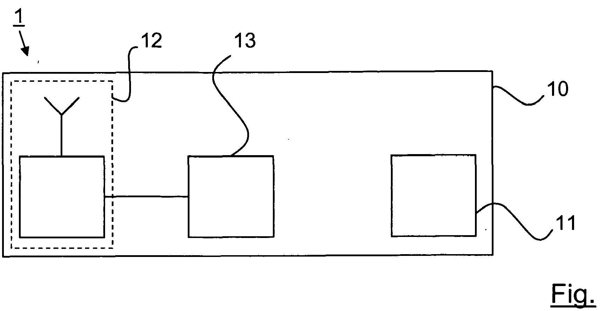

Ausführungsbeispiele der Erfindung werden nachfolgend anhand der Figur näher erläutert. Die Figur zeigt schematisch den erfindungswesentlichen Teil eines erfindungsgemäßen elektrischen Geräts.

### Beschreibung der Ausführungsbeispiele

In der Figur ist ein erfindungemäßes elektrisches Gerät 1 schematisch dargestellt. Bei diesem kann es sich insbesondere um ein Gerät der sogenannten Unterhaltungs- oder Consumer-Elektronik, wie etwa ein Mobiltelefon, einen mobilen Kleinrechner, eine Digitalkamera, ein portables Muskiabspielgerät wie etwa MP3-Player, ein Kombinationsgerät aus mehreren der vorgenannten Einzelgeräte oder dergleichen handeln. Weiterhin kann das elektrische Gerät beispielsweise ein Autoradio, ein Fahrzeugnavigationsgerät, welches auch als mobiles und im Fahrzeug mit einer Halterung (Cradle) installierbares Gerät ausgeführt sein kann, sowie ein sogenanntes Fahrerinformationssystem, welches die Funktionen beispielsweise des Autoradios und Navigationsgeräts und/oder weiterer Komponenten, wie etwa ein Mobiltelefon, integriert, sein. Ein weiteres Beispiel eines erfindungsgemäßen Geräts ist beispielsweise ein Speichermedium, welches elektrische Schaltkreise zur Datenspeicherung aufweist, etwa ein sogenannter USB-Stick, oder Speicherchipkarten in diversen weit verbreiteten Formaten, wie Secure Digital- (SD-) , Multi Media- (MMC), Compact Flash- (CF-) Card.

Dieses Gerät 1 umfasst ein Gehäuse 10, in dem mindestens ein elektrischer Schaltkreis 11 angeordnet ist. Der Schaltkreis 11 kann bei einem prozessorgesteuerten Gerät wie beispielsweise Mobiltelefon, Handheld-Navigationssystem, PDA, Fahrerinformationssystem usw. neben sonstigen Schaltkreisen insbesondere ein Geräteprozessor sein. Im Falle eines Speichergeräts kann der Schaltkreis insbesondere ein Speicherbaustein sein.

Erfindungsgemäß ist im Gehäuse 10 der Geräts ein mikrowellensensitives Element 12, nachfolgend auch Mikrowellensensor, angeordnet. Der Mikrowellensensor 12 ist dazu ausgebildet, einfallende Mikrowellenstrahlung zu erfassen. Der Mikrowellensensor 12 ist in räumlicher Nähe des Schaltkreises 11 angeordnet, vorzugsweise in unmittelbarer Nachbarschaft, im Falle eines ausgedehnten Schaltkreises alternativ auch im Bereich des Schaltkreises, beispielsweise in dessen Zentrum. Der Begriff Schaltkreis ist dabei hier weit auszulegen und umfasst sowohl einzelne elektrische Bauelemente, wie insbesondere integrierte Schaltkreise (ICs), als auch beispielsweise ausgedehnte, aus einer Mehrzahl von elektrischen Bauelementen bestehende Schaltungen, insbesondere solche auf Leiterplatten. Der Mikrowellensensor 12 ist mit einem Speicherelement 13, nachfolgend auch Speicher 13, verbunden. Der Speicher ist dazu ausgelegt, im Falle einer mittels des Mikrowellensensors 12 erfassten Mikrowelleneinstrahlung diesen Sachverhalt dauerhaft und auch ohne Energiezufuhr zu speichern.

Bei einer ersten Ausführungsform der Erfindung können der Mikrowellensensor 12 und der Speicher 13 selbst als elektrische Schaltkreise ausgebildet sein. Insbesondere kann der Speicher 13 als PROM (Programmable Read Only Memory) ausgeführt sein, welches durch ein eine Mikrowelleneinstrahlung anzeigendes Signal des Mikrowellensensors 13 programmiert wird, wobei diese Programmierung vorzugsweise nicht wieder gelöscht werden kann.

Bei einer vorteilhaften Weiterbildung ist vorgesehen, dass der Mikrowellensensor 13 erst dann ein eine Mikrowelleneinstrahlung anzeigendes Signal erzeugt, wenn die Strahlungsintensität und/oder Strahlendosis über einem bestimmten Grenzwert liegt. Der Grenzwert ist dabei so bemessen, dass dieser eine übliche Strahlungsintensität oder -dosis infolge parasitärer Mirkowellenbestrahlung, wie sie beispielsweise bei Betrieb eines Funktelefons oder dergleichen in der Nachbarschaft des elektrischen Geräts typischerweise auftreten kann. Der Grenzwert kann alternativ so bemessen sein, dass dieser um einen bestimmten Sicherheitsabstand unter einer Intensität oder Dosis liegt, die für den elektrischen Schaltkreis 11 des Geräts 1 schädlich ist.

Bei einer zweiten bevorzugen Ausführungsform können das mikrowellensensitive Element 12 und das Speicherelement 13 als ein gemeinsames Sensor- und Speicherelement 12, 13 ausgebildet sein. Beispielsweise kann dieses gemeinsame Sensor- und Speicherelement 12, 13 als metallischer Streifen oder Metallfolie oder dergleichen ausgebildet sein, die sich bei Mikrowellenbestrahlung infolge der dadurch induzierten Wirbelströme erhitzt und in der Folge irreversibel beschädigt oder zerstört wird.

Diese Folie kann beispielsweise auf einen freien oder elektrisch inaktiven Bereich einer Leiterplatte des elektrischen Geräts aufgeklebt oder im Rahmen der Leiterplattenbestückung zusammen mit den weiteren Bauelementen auf der Leiterplatte aufgelötet oder aufgeklebt sein. Die Folie kann alternativ beispielsweise in einem Abschirmgehäuse des elektrischen Schaltkreises oder auch als Teil des Abschirmgehäuses und dann leitend mit diesem verbunden, angeordnet sein. Weiter kann dieses Sensor- und Speicherelement 12, 13 beispielsweise auch als Klebesiegel zur Versiegelung des Gehäuses 10 oder von weiteren innerhalb des Gehäuses angeordneten Elementen an oder in diesem / diesen vorzugsweise unlösbar oder nicht zerstörungsfrei lösbar angebracht sein. Auf diese Weise ist ein besonderer Schutz gegen Manipulation durch Unbefugte gegeben.

Alternativ kann das Sensor- und Speicherelement 12, 13 auch als elektrischer Schwingkreis ausgebildet sein, dessen Resonanzfrequenz im Bereich üblicher Mikrowellensender liegt. Im Falle eines Mobilfunktelefons kann dieser Schwingkreis vorzugsweise an die Antenne des Geräts angekoppelt sein. Wird der Schwingkreis durch eine Mikrowellenbestrahlung mit ausreichend hoher Intensität in seiner Resonanzfrequenz angeregt, überschreitet die im Schwingkreis gespeicherte Energie eine bestimmte Schwelle, oberhalb der zumindest einzelne Elemente des Schwingkreises irreversibel zerstört werden. Die Zerstörung des oder von Teilen des Schwingkreises zeigt zuverlässig eine Mikrowellenbestrahlung mit einer über eine Schwelle liegenden Intensität an. Der Schwingkreis stellt also sowohl Sensorelement als auch Speicherelement dar.

Das Speicherelement 13 braucht nicht notwendig in unmittelbarer Nachbarschaft oder Nähe des Sensorelements 12 angeordnet zu sein. Wesentlich ist, dass das Sensorelement 12 so positioniert ist, dass es eine Mikrowellenbestrahlung des elektrischen Schaltkreises 11 oder des Geräts 1 als solchem sicher erfasst, so dass ein Manipulationsversuch durch Mikrowellenbestrahlung sicher nachweisbar ist. Der Speicher 13 kann vom Sensor 12 abgesetzt angeordnet sein.

Vorteilhaft ist insbesondere das Sensorelement von dem elektrischen Schaltkreis elektrisch entkoppelt. Dadurch kann insbesondere im Falle eines aktiven Sensorelements sichergestellt werden, dass das Sensorelement auch dann noch ein eine Mikrowellenbestrahlung anzeigendes Signal erzeugen kann, wenn der elektrische Schaltkreis infolge der Bestrahlung bereits zerstört oder zumindest in Teilen funktionsunfähig ist.

## Patentansprüche

1. Elektrisches Gerät (1), umfassend einen elektrischen Schaltkreis (11), **gekennzeichnet durch** ein in räumlicher Nähe zum elektrischen Schaltkreis (11) angeordnetes mikrowellensensitives Element (12) zur Erfassung einer auf den elektrischen Schaltkreis (11) einwirkenden Mikrowellenstrahlung und ein Speicherelement (13) zur Speicherung einer mit dem mikrowellensensitiven Element (12) erfassten Mikrowellenexposition des elektrischen Schaltkreises (11), wobei das mikrowellensensitive Element (12) und das Speicherelement (13) als elektrische Schaltkreise ausgebildet sind, wobei das mikrowellensensitive Element (12) dann ein Signal erzeugt, wenn die Strahlungsintensität und/oder Strahlendosis der auf den elektrischen Schaltkreis (11) einwirkenden Mikrowellenstrahlung über einem bestimmten Grenzwert liegt, der so bemessen wird, dass der Grenzwert um einen bestimmten Sicherheitsabstand unter einer Intensität oder Dosis liegt, die für den elektrischen Schaltkreis (11) des elektrischen Geräts (1) schädlich ist.

2. Elektrisches Gerät nach Anspruch 1, **gekennzeichnet durch** ein Gehäuse (10), in welchem der elektrische Schaltkreis (11) angeordnet ist und **durch** eine Anordnung des mikrowellensensitiven Elements (12) und des Speicherelements (13) in dem Gehäuse.

3. Elektrisches Gerät nach Anspruch 1 oder 2, **dadurch gekennzeichnet, dass** das Sensorelement (12) und/oder das Speicherelement (13) von dem elektrischen Schaltkreis (11) elektrisch entkoppelt ist.

## Claims

1. Electrical device (1), comprising an electrical circuit (11), **characterized by** a microwave-sensitive element (12) arranged in spatial proximity to the electrical circuit (11) and serving for detecting a microwave radiation acting on the electrical circuit (11), and a storage element (13) for storing a microwave exposure of the electrical circuit (11) as detected by the microwave-sensitive element (12), wherein the microwave-sensitive element (12) and the storage element (13) are embodied as electrical circuits, wherein the microwave-sensitive element (12) generates a signal if the radiation intensity and/or radiation dose of the microwave radiation acting on the electrical circuit (11) are/is above a specific limit value dimensioned such that the limit value is lower, by a specific safety margin, than an intensity or dose that is harmful to the electrical circuit (11) of the electrical device (1).

2. Electrical device according to Claim 1, **characterized by** a housing (10), in which the electrical circuit (11) is arranged, and by an arrangement of the microwave-sensitive element (12) and the storage element (13) in the housing.

3. Electrical device according to Claim 1 or 2, **characterized in that** the sensor element (12) and/or the storage element (13) are/is electrically decoupled from the electrical circuit (11).

## Revendications

1. Appareil électrique (1), comprenant un circuit électrique (11), **caractérisé par** un élément sensible aux micro-ondes (12) disposé à proximité spatiale du circuit électrique (11) pour détecter un rayonnement à micro-ondes agissant sur le circuit électrique (11) et un élément de stockage (13) pour stocker une exposition aux micro-ondes du circuit électrique (11) détectée par l'élément sensible aux micro-ondes (12), l'élément sensible aux micro-ondes (12) et l'élément de stockage (13) étant réalisés sous forme de circuits électriques, l'élément sensible aux micro-ondes (12) générant un signal lorsque l'intensité du rayonnement et/ou la dose de rayonnement du rayonnement à micro-ondes agissant sur le circuit électrique (11) dépasse une valeur limite déterminée qui est dimensionnée de telle sorte que la valeur limite soit située à une certaine distance de sécurité en dessous d'une intensité ou d'une dose qui est dommageable pour le circuit électrique (11) de l'appareil électrique (1).

2. Appareil électrique selon la revendication 1, **caractérisé par** un boîtier (10) dans lequel est disposé le circuit électrique (11) et par un agencement de l'élément sensible aux micro-ondes (12) et de l'élément de stockage (13) dans le boîtier.

3. Appareil électrique selon la revendication 1 ou 2, **caractérisé en ce que** l'élément de capteur (12) et/ou l'élément de stockage (13) sont désaccouplés électriquement du circuit électrique (11).
